# EUROPEAN PATENT APPLICATION

(11) **EP 4 411 515 A1**
(43) Date of publication of application: **07.08.2024**
(21) Application number: 23155138.3
(22) Date of filing: 06.02.2023
(51) Int. Cl.: G06F 3/01

(54) **AN APPARATUS FOR PROVIDING FEEDBACK**

(71) Applicant: Aito BV, 1043 EJ Amsterdam (NL)
(72) Inventor: Keski-Jaskari, Turo, 04370 Tuusula (FI); Koskinen, Jouni, 01700 Helsinki (FI)
(74) Representative: Papula Oy

(57) **Abstract**

An apparatus (100) comprising at least two piezoelectric element groups (302, 304, 308, 310), wherein each piezoelectric element group comprises at least one piezoelectric element (202) to provide feedback; and at least two control circuits (104A, 104B). Each piezoelectric element group (302, 304, 308, 310) is configured to be controlled independently and differently by a respective control circuit of the at least two control circuits (104A, 104B) and wherein each control circuit of the at least two control circuits (104A, 104B) is configured to selectively control at least one piezoelectric element of the respective piezoelectric element group.

## Description

### FIELD OF THE INVENTION

The invention concerns the technology of generating haptic effects in electromechanical user interface devices. In particular the invention concerns a solution for providing a feedback, for example, haptic feedback.

### BACKGROUND OF THE INVENTION

Piezoelectric elements are commonly used to generate haptic effects, i.e. recreation of the sense of touch by applying forces, vibrations, or motions to the user, in input devices such as touchkeys, touchscreens, touchpads and the like. For example, a piezoelectric element can be used both to sense a pressing force applied by the user and to generate the haptic feedback. The first-mentioned involves sensing a voltage that the piezoelectric element generates in response to mechanical deformation, and the latter involves applying a voltage waveform to the piezoelectric element that temporarily deforms it mechanically, causing a corresponding elastic movement in the surrounding structures.

Currently, when a user may be given a haptic feedback in response to a touch, for example, with a finger, the user knows that he or she touched a surface but the haptic feedback does not provide any additional information to the user.

### SUMMARY

This summary is provided to introduce a selection of concepts in a simplified form that are further described below in the detailed description. This summary is not intended to identify key features or essential features of the claimed subject matter, nor is it intended to be used to limit the scope of the claimed subject matter.

Example embodiments may provide a solution that may enable provision of enhanced feedback, for example, haptic feedback, to a user. This benefit may be achieved by the features of the independent claims. Further implementation forms are provided in the dependent claims, the description, and the drawings.

According to a first aspect there is provided an apparatus comprising at least two piezoelectric element groups, wherein each piezoelectric element group comprises at least one piezoelectric element to provide feedback; and at least two control circuits. Each piezoelectric element group is configured to be controlled independently and differently by a respective control circuit of the at least two control circuits and wherein each control circuit of the at least two control circuits is configured to selectively control at least one piezoelectric element of the respective piezoelectric element group. This may enable implementing a haptic sensor or a haptic touch module that is able to provide more versatile feedback, for example, haptic feedback.

In an implementation form of the first aspect, at least two piezoelectric element groups are configured to be controlled by their associated control circuits to provide simultaneous haptic feedback.

In an implementation form of the first aspect, at least two control circuits are configured to temporally vary driving their associated piezoelectric element groups.

In an implementation form of the first aspect, at least two control circuits are configured to vary the phase-shift of signals when driving their associated piezoelectric element groups.

In an implementation form of the first aspect, a first control circuit is configured to control a first piezoelectric element group to provide haptic feedback and a second control circuit is configured to control a second piezoelectric element group to provide audio feedback.

In an implementation form of the first aspect, a first control circuit is configured to control a first piezoelectric element group to provide haptic feedback, and a second control circuit is configured to control a second piezoelectric element group to sense touch.

According to a second aspect there is provided a device comprising the apparatus of the first aspect.

According to a third aspect there is provided a method for providing feedback with an apparatus of the first aspect, the method comprising: controlling the at least two controlling circuits to control each piezoelectric element group independently and differently by a respective control circuit of the at least two control circuits; and controlling each control circuit of the at least two control circuits to selectively control at least one piezoelectric element of the respective piezoelectric element group.

According to a fourth aspect, a computer program comprises instructions for causing an apparatus to carry out the method of the third aspect.

According to a fifth aspect, a computer readable medium comprises a computer program comprising instructions for causing an apparatus to carry out the method of the third aspect.

According to a sixth aspect, there is provided a controller configured to: control at least two controlling circuits to control a piezoelectric element group associated with a respective controlling circuit independently and differently, wherein each piezoelectric element group comprises at least one piezoelectric element to provide feedback; and control each control circuit of the at least two control circuits to selectively control at least one piezoelectric element of the respective piezoelectric element group.

In an implementation form of the sixth aspect, the controller is configured to control at least two control circuits to control their associated piezoelectric element groups to provide simultaneous feedback.

In an implementation form of the sixth aspect, the controller is configured to control at least two control circuits to control their associated piezoelectric element groups to temporally vary driving their associated piezoelectric element groups.

In an implementation form of the sixth aspect, the controller is configured to control at least two control circuits to control their associated piezoelectric element groups to vary the phase-shift of signals when driving their associated piezoelectric element groups.

In an implementation form of the sixth aspect, the controller is configured to control a first control circuit to control a first piezoelectric element group to provide haptic feedback and a second control circuit to control a second piezoelectric element group to provide audio feedback.

In an implementation form of the sixth aspect, the controller is configured to control a first control circuit to control a first piezoelectric element group to provide haptic feedback and a second control circuit to control a second piezoelectric element group to sense touch.

### BRIEF DESCRIPTION OF THE DRAWINGS

The accompanying drawings, which are included to provide a further understanding of the invention and constitute a part of this specification, illustrate embodiments of the invention and together with the description help to explain the principles of the invention. In the drawings:
**FIG. 1** illustrates a block diagram of an apparatus according to an example embodiment.
**FIG. 2** illustrates an example structure of a haptic sensor according to an example embodiment.
**FIG. 3A** illustrates a structure of a haptic sensor according to an example embodiment.
**FIG. 3B** illustrates a structure of a haptic sensor according to another example embodiment.
**FIG. 4** illustrates examples of possible driving signals of a piezoelectric element according to an example embodiment.
**FIG. 5** illustrates an example of a method according to an example embodiment.

### DETAILED DESCRIPTION

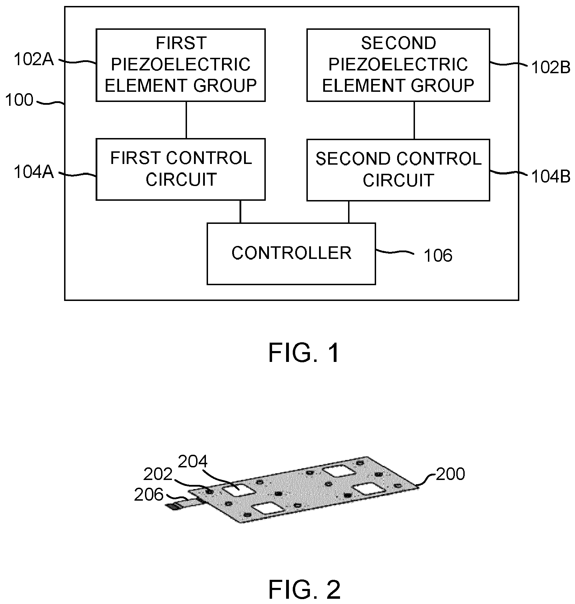

FIG. 1 illustrates a block diagram of an apparatus 100 according to an example embodiment. In an example embodiment, the apparatus 100 may refer to a haptic touch module. The apparatus comprises a first piezoelectric element group 102A and a second piezoelectric element group 102B. The first piezoelectric element group 102A and the second piezoelectric element group 102B each comprises a plurality of piezoelectric elements to provide haptic feedback. A piezoelectric element may also be referred to as a piezoelectric actuator, a piezo sensor, a haptic feedback element, a tactile feedback element, a piezo actuator, a piezoelectric transducer, a piezo transducer, or similar.

The first piezoelectric element group 102A is controlled by a first control circuit 104A and the second piezoelectric element group 102B is controlled by a second control circuit 104B. Each piezoelectric element group 102A, 102B may be configured to be controlled independently and differently by the respective control circuit 104A, 104B and each control circuit of the control circuits 104A, 104B is configured to selectively control at least one piezoelectric element of the respective piezoelectric element group. "Selectively control" may mean, for example, that a control circuit may control only a subset (i.e. one or more piezoelectric elements) of all the piezoelectric elements relating to a piezoelectric element group associated with the control circuit. In an example embodiment, the first and second piezoelectric element groups 102A, 102B may provide an interleaved grouping of the piezoelectric elements. In an example embodiment, the first and second control circuits 104A, 104B may be application specific integrated circuits (ASIC). In an example embodiment, the apparatus 100 may comprise more than two piezoelectric element groups and more than two control circuits. In an example embodiment, the piezoelectric element groups and the control circuits may be configured on the same printed circuit board (PCB) or a flexible printed circuit (FPC).

In an example embodiment, the first control circuit 104A and the second control circuit 104B may comprise an analogue front end (AFE) and/or a booster circuit or an application specific integrated circuit (ASIC). The booster circuit/ASIC may also be referred to as a voltage booster circuit/ASIC or similar.

In an example embodiment, the apparatus 100 may comprise a controller 106, i.e. the controller 106 may be integral to the apparatus 100, and the controller 106 may be configured to control the first control circuit 104A and the second control circuit 104B to provide a high voltage for driving the piezoelectric elements. In another example embodiment, the controller 106 be external to the apparatus 100.

FIG. 2 illustrates an example structure of a haptic sensor 200 comprising a plurality of piezoelectric elements 202. The haptic sensor 200 may be part of a larger element, for example, as a haptic touch module. It should be noted that the example of FIG. 2 illustrates just one of a number of possible implementations for implementing a haptic sensor 200. A variety of other possible implementations exist, as is clear to the person skilled in the art in the light of the following description of how the various parts of the haptic sensor 200 can be dimensioned and formed. The haptic sensor 200 may further comprise a piezo foil comprising electrical tracks for contacting the piezoelectric elements 202 to electronics and providing protection to the piezoelectric elements 202. The piezoelectric elements 202 may be attached under the piezo foil, for example, with an electrically conductive glue, by soldering or using any appropriate attachment solution. The haptic sensor 200 may comprise one or more through holes 204, for example, rectangular through holes, as a space reservation for other components. Separate control circuits 104A, 104B may be connected to the haptic sensor 200 via a connecting cable 206 to control the piezoelectric elements 202 of the haptic sensor 200. In an example embodiment, the control circuits 104A, 104B may be application specific integrated circuits (ASIC). As a summary, the haptic sensor 104 may provide both sensing of a touch and a haptic feedback to a user.

The piezoelectric elements 202 may be grouped to two or more groups and each piezoelectric element group is independently and differently controlled by a respective control circuit. Each control circuit of the at least two control circuits may be configured to selectively control at least one piezoelectric element of the respective piezoelectric element group. "Selectively control" may mean, for example, that a control circuit may control only a subset (i.e. one or more piezoelectric elements) of all the piezoelectric elements relating to a piezoelectric element group associated with the control circuit. In an example embodiment, the at least two piezoelectric element groups may provide an interleaved grouping of the piezoelectric elements 202. In other example embodiments, any other grouping structure may be used, for example, dividing the groups to left side and right side.

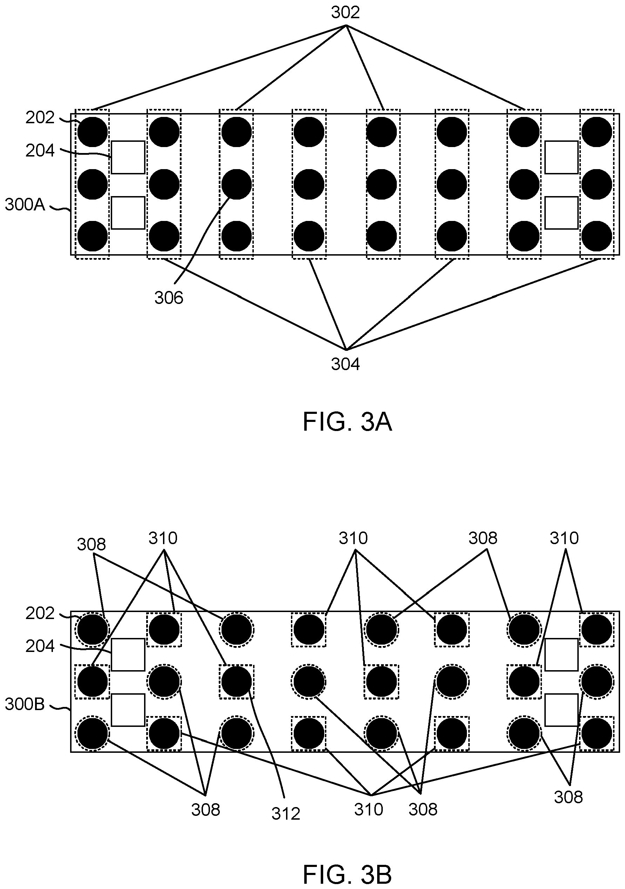

FIG. 3A illustrates a structure of a haptic sensor 300A according to an example embodiment. The haptic sensor 300A comprises a plurality of piezoelectric elements 202. The piezoelectric elements 202 are grouped into two piezoelectric element groups, a first piezoelectric element group 302 and a second piezoelectric element group 304. The haptic sensor 300A provides an interleaved grouping of the piezoelectric elements 202, and each piezoelectric element group 302, 304 is independently and differently controlled by a respective control circuit, for example, an application specific integrated circuit. In FIG. 3A, the piezoelectric element groups 302, 304 have been implemented vertically so that vertical sections of the piezoelectric element groups 302, 304 alternate with each other. Although FIG. 3A illustrates a specific grouping type of the piezoelectric elements 202 and that there are two piezoelectric element groups 302, 304, in other embodiments, the grouping type may be different and/or there may be more than two piezoelectric element groups.

When feedback, for example, haptic feedback is provided with a device having a surface and the haptic sensor 300A, the surface of the device needs to slightly deform locally on the positions where haptic feedback is given. The same may apply when the piezoelectric elements are used for sensing.

In an example embodiment of FIG. 3A, the two piezoelectric element groups 302, 304 are controlled by their respective control circuits to provide simultaneous and different haptic feedback with respect to each other. For example, if a user touches a surface at a point corresponding to a piezoelectric element 306 belonging to the first piezoelectric element group 302 and haptic feedback is provided with the piezoelectric elements of the first piezoelectric element group 302 in response to the touch, the piezoelectric elements of the second piezoelectric element group 304 may be controlled to provide haptic feedback that is different than that of provided by the first piezoelectric element group 302. For example, all or some of the piezoelectric elements of the second piezoelectric element group 304 may be controlled to provide a smaller (or different) amount of haptic feedback than provided with all of some of the piezoelectric elements of the first piezoelectric element group 302. This may enable a solution in which different signals are simultaneously driven to the piezoelectric element groups to affect the same finger from different directions. Further, this may enable to better imitate sharp edges and voids between keys of a virtual keyboard. Further, the user may be able to distinguish a direction without moving the finger as something may be "left" or "right" from the finger's current location as a result of the haptic feedback provided to the user.

In another example embodiment, a depth effect or a spring effect can be utilized per each piezoelectric element group simultaneously, for example, to simulate one side of the finger going deeper than the other side to emulate tilted surface going down from finger's point of view. In the depth effect, feedback pulses may be given with an increasing rate with an increasing pressure. The spring effect may be provided by giving feedback pulses according to the physical model of spring.

In an example embodiment of FIG. 3A, the temporal relation of driving the first and second piezoelectric element groups 302, 304 can be varied, either fully separate in time, or in a phase-shifted manner. For example, the haptic feedback provided by the piezoelectric elements of the first and second piezoelectric element groups 302, 304 may be temporally alternated between the piezoelectric elements of the first and second piezoelectric element groups 302, 304. This may thus enable, for example, a pulsating alert to be provided to the user.

FIG. 3B illustrates a structure of a haptic sensor 300B according to an example embodiment. The haptic sensor 300B comprises a plurality of piezoelectric elements 202. The piezoelectric elements 202 are grouped into two piezoelectric element groups, a first piezoelectric element group 308 and a second piezoelectric element group 310. The haptic sensor 300B provides an interleaved grouping of the piezoelectric elements 202, and each piezoelectric element group 308, 310 is independently and differently controlled by a respective control circuit, for example, an application specific integrated circuit. In FIG. 3B, the piezoelectric elements 202 are grouped to two piezoelectric element groups 308, 310 so that in vertical and horizontal directions, a piezoelectric element of the first piezoelectric element group 308 is adjacent to a piezoelectric element of the second piezoelectric element group 310. Although FIG. 3B illustrates a specific grouping type of the piezoelectric elements 202 and that there are two piezoelectric element groups 308, 310, in other embodiments, the grouping type may be different and/or there may be more than two piezoelectric element groups.

When feedback, for example, haptic feedback is provided with a device having a surface and haptic sensor 300B, the surface of the device needs to slightly deform locally on the positions where haptic feedback is given. The same may apply when the piezoelectric elements are used for sensing.

In an example embodiment of FIG. 3B, the two piezoelectric element groups 308, 310 are controlled by their respective control circuits to provide simultaneous and different haptic feedback with respect to each other. For example, if a user touches a surface at a point corresponding to a piezoelectric element 312 belonging to the second piezoelectric element group 310 and haptic feedback is provided with the piezoelectric elements of the second piezoelectric element group 310 in response to the touch, the piezoelectric elements of the first piezoelectric element group 308 may be controlled to provide haptic feedback that is different than that of provided by the second piezoelectric element group 310. For example, all or some of the piezoelectric elements of the second piezoelectric element group 310 may be controlled to provide a smaller (or different) amount of haptic feedback than provided with all or some of the piezoelectric elements of the first piezoelectric element group 308. This may enable a solution in which different signals are simultaneously driven to the piezoelectric element groups to affect the same finger from different directions. Further, this may enable to better imitate sharp edges and voids between keys of a virtual keyboard. Further, the user may be able to distinguish a direction without moving the finger as something may be "left", "up", "right" or "down" from the finger's current location as a result of the haptic feedback provided to the user.

In another example embodiment, a depth effect or a spring effect can be utilized per each piezoelectric element group simultaneously, for example, to simulate one side of the finger going deeper than the other side to emulate tilted surface going down from finger's point of view. In the depth effect, feedback pulses may be given with an increasing rate with an increasing pressure. The spring effect may be provided by giving feedback pulses according to the physical model of spring.

In an example embodiment of FIG. 3B, the temporal relation of driving the first and second piezoelectric element groups 308, 310 can be varied, either fully separate in time, or in a phase-shifted manner. For example, the haptic feedback provided by the piezoelectric elements of the first and second piezoelectric element groups 308, 310 may be temporally alternated between the piezoelectric elements of the first and second piezoelectric element groups 302, 304. This may thus enable, for example, a pulsating alert to be provided to the user.

In an example embodiment, a device, for example, a mobile device, a tablet computer, a keyboard, a display etc. may comprise the haptic sensor 300A, 300B illustrated in FIG. 3A or 3B or the apparatus 100 illustrated in FIG. 1.

The examples illustrated in FIGS. 3A and 3B use two piezoelectric element groups arranged in a symmetrical manner. In other example embodiments, the number of piezoelectric element groups may be more than two. Further, in other example embodiments, the pattern of the at least two piezoelectric element groups may be different than that of illustrated in FIGS. 3A and 3B, for example, a non-symmetrical pattern.

In an example embodiment of FIG. 3A and/or FIG. 3B, piezoelectric elements belonging to the second piezoelectric element group can be used for sensing during the haptic pulse fed to piezoelectric elements of the first piezoelectric element group. The sensed signals can be used, for example, for better finger sensing, or self-calibration, self-adaption, etc. according to mechanical tolerances, environment conditions, etc. Without piezoelectric elements grouping sensing and haptic driving would have to be time-interleaved. With individual piezoelectric element groups it is possible to drive one piezoelectric element group and get information from the second piezoelectric element group simultaneously.

In an example embodiment of FIG. 3A and/or 3B, the use of at least two different piezoelectric element groups also enables a solution in which a first piezoelectric element group can be used to provide haptic feedback and a second piezoelectric element group can be used to provide audio. Audio is an integral part of haptics, as the frequency ranges overlap each other. Audio frequencies and intensity have an impact on a perceived feedback of a user. For example, the perceived feedback can be altered by playing audio in the second piezoelectric element group without changing the haptic feedback provided by the first piezoelectric element group for the user's finger.

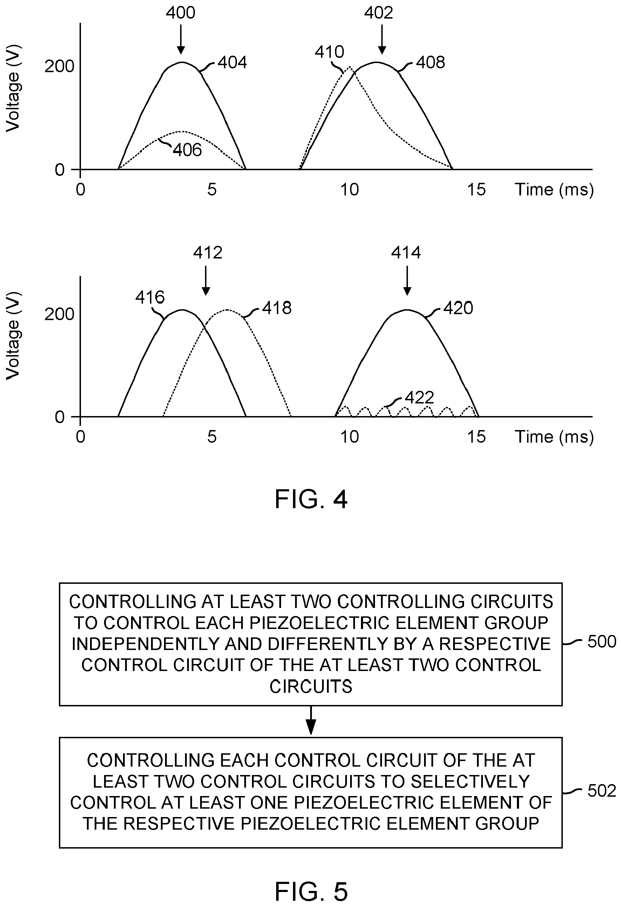

FIG. 4 illustrates examples of possible driving signals of a piezoelectric element according to an example embodiment.

In a first example 400, a first piezo driving signal 404 has a different amplitude than a second piezo driving signal 406. In a second example 402, a first piezo driving signal 408 has a different shape than a second piezo driving signal 410. In a third example 412, a first piezo driving signal 416 has a different phase than a second piezo driving signal 418. In a fourth example 414, a first piezo driving signal 420 provides haptic feedback and a second piezo driving signal 422 provides audio feedback.

FIG. 5 illustrates an example of a method according to an example embodiment. The method may be performed, for example, by a microcontroller unit (MCU).

At 500, the at least two controlling circuits 104A, 104B are controlled to control each piezoelectric element group 302, 304, 308, 310 independently and differently by a respective control circuit of the at least two control circuits 104A, 104B.

At 502, each control circuit of the at least two control circuits 104A, 104B are controlled to selectively control at least one piezoelectric element of the respective piezoelectric element group. A piezoelectric element may also be referred to as a piezoelectric actuator, a piezo sensor, a haptic feedback element, a tactile feedback element, a piezo actuator, a piezoelectric transducer, a piezo transducer, or similar.

The functionality described herein may be performed, at least in part, by one or more computer program product components such as software components. According to an embodiment, an apparatus may comprise a processor or processor circuitry, for example, a microcontroller, configured by the program code when executed to execute the embodiments of the operations and functionality described herein. The program code is provided as an example of instructions which, when executed by the at least one processor, cause performance of apparatus. Alternatively, or in addition, the functionality described herein can be performed, at least in part, by one or more hardware logic components. For example, and without limitation, illustrative types of hardware logic components that can be used include Field-programmable Gate Arrays (FPGAs), Application-Specific Integrated Circuits (ASICs), Application-Specific Standard Products (ASSPs), System-on-a-chip systems (SOCs), Complex Programmable Logic Devices (CPLDs), and Graphics Processing Units (GPUs).

Further, the computer program may comprise instructions for causing, when executed, the apparatus to perform the method described herein. The computer program may be stored on a computer-readable medium. Further, the apparatus may comprise means for performing the method described herein. In one example, the means may comprise the at least one processor, the at least one memory including the program code (instructions) configured to, when executed by the at least one processor, cause the apparatus to perform the method(s). In general, computer program instructions may be executed on means providing generic processing functions. The method may be thus computer-implemented, for example, based on algorithm(s) executable by the generic processing functions, an example of which is the at least one processor.

It is obvious to a person skilled in the art that with the advancement of technology, the basic idea of the invention may be implemented in various ways. For example, dimensions and forms of the illustrated elements may vary. The invention and its embodiments are thus not limited to the examples described above, instead they may vary within the scope of the claims.

## Claims

1. An apparatus (100), comprising:
at least two piezoelectric element groups (302, 304, 308, 310), wherein each piezoelectric element group comprises at least one piezoelectric element (202) to provide feedback; and
at least two control circuits (104A, 104B);
wherein each piezoelectric element group (302, 304, 308, 310) is configured to be controlled independently and differently by a respective control circuit of the at least two control circuits (104A, 104B) and wherein each control circuit of the at least two control circuits (104A, 104B) is configured to selectively control at least one piezoelectric element of the respective piezoelectric element group.

2. The apparatus (100) according to claim 1, wherein at least two piezoelectric element groups (302, 304, 308, 310) are configured to be controlled by their associated control circuits to provide simultaneous feedback.

3. The apparatus (100) according to claim 1 or 2, wherein at least two control circuits (104A, 104B) are configured to temporally vary driving their associated piezoelectric element groups (302, 304, 308, 310).

4. The apparatus (100) according to any one of claims 1 - 3, wherein at least two control circuits (302, 304, 308, 310) are configured to vary the phase-shift of signals when driving their associated piezoelectric element groups (302, 304, 308, 310).

5. The apparatus (100) according to any one of claims 1 - 4, wherein:
a first control circuit is configured to control a first piezoelectric element group to provide haptic feedback and a second control circuit is configured to control a second piezoelectric element group to provide audio feedback.

6. An apparatus (100) according to any one of claims 1 - 5, wherein:
a first control circuit is configured to control a first piezoelectric element group to provide haptic feedback; and
a second control circuit is configured to control a second piezoelectric element group to sense touch.

7. A device comprising the apparatus (100) of any of claims 1 - 6.

8. A method for providing feedback with an apparatus (100) of any of claims 1 - 6, the method comprising:
controlling the at least two controlling circuits (104A, 104B) to control each piezoelectric element group (302, 304, 308, 310) independently and differently by a respective control circuit of the at least two control circuits (104A, 104B); and
controlling each control circuit of the at least two control circuits (104A, 104B) to selectively control at least one piezoelectric element of the respective piezoelectric element group.

9. A computer program comprising instructions for causing an apparatus to carry out the method of claim 8.

10. A controller (106) configured to:
control at least two controlling circuits (104A, 104B) to control a piezoelectric element group (302, 304, 308, 310) associated with a respective controlling circuit independently and differently, wherein each piezoelectric element group comprises at least one piezoelectric element (202) to provide feedback; and
control each control circuit of the at least two control circuits (104A, 104B) to selectively control at least one piezoelectric element of the respective piezoelectric element group.
